# EUROPEAN PATENT APPLICATION

(11) **EP 4 484 462 A1**
(43) Date of publication of application: **01.01.2025**
(21) Application number: 23759722.4
(22) Date of filing: 10.02.2023
(51) Int. Cl.: C08G 59/40, C08G 65/18, G03F 7/004

(54) **RESIN COMPOSITION, RESIN COMPOSITION COATING FILM, RESIN COMPOSITION FILM, CURED FILM, AND SEMICONDUCTOR DEVICE USING THESE PRODUCTS**

(30) Priority: 24.02.2022 JP 2022026410
(71) Applicant: Toray Industries, Inc., Tokyo 103-8666 (JP)
(72) Inventor: KATO, Keigo, Otsu-shi, Shiga 520-8558 (JP); MATSUMURA, Kazuyuki, Otsu-shi, Shiga 520-8558 (JP); TATEOKA, Yoshiko, Otsu-shi, Shiga 520-8558 (JP); SHIMADA, Akira, Otsu-shi, Shiga 520-8558 (JP)
(74) Representative: Kador & Partner Part mbB
(86) International application number: PCT/JP2023/004533
(87) International publication number: WO 2023/162718

(57) **Abstract**

Disclosed is a resin composition including at least one polymer compound selected from the group consisting of polyamide, polyimide, polyamideimide and polybenzoxazole as a component (A), a cationic polymerizable compound as a component (B), and a photocationic polymerization initiator as a component (C), wherein the component (B) contains both an epoxy compound as a component (B1) and an oxetane compound as a component (B2). The present invention provides a resin composition which has sufficient mechanical properties and thermal properties and is capable of forming a pattern with thick film and high aspect ratio.

## Description

### TECHNICAL FIELD

The present invention relates to a resin composition, a resin composition coating film, a resin composition film, a cured film, and a semiconductor device using these products. More specifically, the present invention relates to a resin composition suited for use in surface protective films for semiconductor elements and inductor devices, interlayer insulating films, and structures for microelectronic mechanical systems (MEMS).

### BACKGROUND ART

Heretofore, polyimide-based materials and polybenzoxazole-based materials, which are excellent in heat resistance, electrical insulation properties and mechanical properties, have been widely used for surface protective films and interlayer insulating films of semiconductor elements. With the recent demand for higher density and higher performances of semiconductor elements, photosensitive materials are required for surface protective films and interlayer insulating films from the viewpoint of production efficiency.

Meanwhile, photosensitive materials are required to be processed with high aspect ratio for various packaging structures of recent semiconductor elements and MEMS. To meet such demands, photosensitive materials of chemically amplified photocationic polymerization system have been disclosed (for example, Patent Document 1). There have also been disclosed photocationic polymerizable materials intended to improve mechanical properties and thermal properties by including an epoxy resin having a specific structure in chemically amplified photocationic polymerization system (for example, Patent Document 2). There have also been disclosed photocationic polymerizable materials, which are excellent in glass transition temperature, tensile strength and tensile elongation of a cured film, by including a polymer compound such as polyimide in chemically amplified photocationic polymerization system (for example, Patent Document 3).

### PRIOR ART DOCUMENTS

### PATENT DOCUMENTS

Patent Document 1: WO 2008/007764 A
Patent Document 2: JP 2019-38964 A
Patent Document 3: JP 2021-055055 A

### SUMMARY OF THE INVENTION

### PROBLEMS TO BE SOLVED BY THE INVENTION

However, it was difficult for the above-mentioned photocationic polymerizable materials to obtain sufficient mechanical properties and thermal properties and to form a pattern with thick film and high aspect ratio. It was difficult for the photocationic polymerizable materials disclosed in Patent Documents 1 and 2 to achieve both sufficient mechanical properties and thermal properties. It was difficult for the photocationic polymerizable material containing a polymer compound such as polyimide disclosed in Patent Document 3 to form a pattern with thick film and high aspect ratio.

In light of these circumstances, an object of the present invention is to provide a resin composition which has sufficient mechanical properties and thermal properties and is capable of forming a pattern with thick film and high aspect ratio.

### SOLUTIONS TO THE PROBLEMS

In light of these circumstances, the authors have intensively studied and found that the above problems can be solved by using a photocationic polymerizable material containing a polymer compound such as polyimide and both an epoxy compound and an oxetane compound as cationic polymerizable compounds.

The present invention for solving the above problems is as follows.

A resin composition including at least one polymer compound selected from the group consisting of polyamide, polyimide, polyamideimide and polybenzoxazole as a component (A), a cationic polymerizable compound as a component (B), and a photocationic polymerization initiator as a component (C), wherein
the component (B) contains both an epoxy compound as a component (B1) and an oxetane compound as a component (B2) .

### EFFECTS OF THE INVENTION

The resin composition of the present invention provides a resin composition which has sufficient mechanical properties and thermal properties and is capable of forming a pattern with thick film and high aspect ratio, a resin composition coating film, a resin composition film, a cured film, and a semiconductor device and an inductor using these products.

### BRIEF DESCRIPTION OF THE DRAWINGS

FIG. 1 is a cross-sectional view schematically showing distortion of a pattern obtained by developing a resin composition laminated on a base material.
FIG. 2 is a cross-sectional view schematically showing an inductor.

### EMBODIMENTS OF THE INVENTION

The resin composition of the present invention is a resin composition including at least one polymer compound selected from the group consisting of polyamide, polyimide, polyamideimide and polybenzoxazole as a component (A), a cationic polymerizable compound as a component (B), and a photocationic polymerization initiator as a component (C), wherein the component (B) contains both an epoxy compound as a component (B1) and an oxetane compound as a component (B2) .

The resin composition of the present invention is preferably a negative photosensitive resin composition in which the component (C) generates an acid upon light irradiation, which causes the (B) component to undergo a polymerization reaction, resulting in insolubility in a developer, that is, a negative photosensitive resin composition.

### <Component (A)>

The resin composition of the present invention includes, as the component (A), at least one polymer compound selected from the group consisting of polyamide, polyimide, polyamideimide and polybenzoxazole. By including the component (A), the resin composition of the present invention is excellent in film-forming properties when the resin composition of the present invention is used to form a film-like resin composition coating film or the like. The polymer compounds in the component (A) may be used alone or in combination of two or more thereof.

The weight-average molecular weight of the component (A) is not particularly limited, but is preferably 1,000 or more and 200,000 or less. The weight-average molecular weight of the polymer compound in the component (A) in the present invention is determined by measuring using a gel permeation chromatographic method (GPC method) and calculating in terms of polystyrene.

It is also important that the resin composition of the present invention includes at least one polymer compound selected from the group consisting of polyamide, polyimide, polyamideimide and polybenzoxazole. As long as the resin composition includes at least one polymer compound selected from the group consisting of polyamide, polyimide, polyamideimide and polybenzoxazole, it is also possible to include a polymer compound other than polyamide, polyimide, polyamideimide and polybenzoxazole. A polyimide precursor and a polybenzoxazole precursor respectively correspond to the above-mentioned polyamide.

Furthermore, the component (A) preferably has a structure in which the molecular chain terminal is derived from the carboxylic acid residue. When the molecular chain terminal of the component (A) has a structure derived from the carboxylic acid residue, the molecular chain terminal can have a molecular structure that does not have an amine end structure which can serve as an inhibitory functional group for cationic polymerization, thus making it possible to exhibit sufficient cationic polymerizability. Here, the structure derived from the carboxylic acid residue at the molecular chain terminal of the component (A) means an organic group derived from the carboxylic acid residue that can constitute polyamide, polyimide or polyamideimide.

Examples of the structure (organic group) derived from the carboxylic acid residue at the molecular chain terminal of the component (A) include, but are not limited to, structures derived from an aromatic dicarboxylic acid, an aromatic dianhydride, an alicyclic dicarboxylic acid, an alicyclic acid dianhydride, an aliphatic dicarboxylic acid, an aliphatic acid dianhydride and the like. These can be used alone or in combination of two or more thereof.

In the present invention, the component (A) is preferably a compound having at least one structure selected from structures represented by the general formulas (1) and (2).

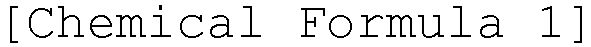

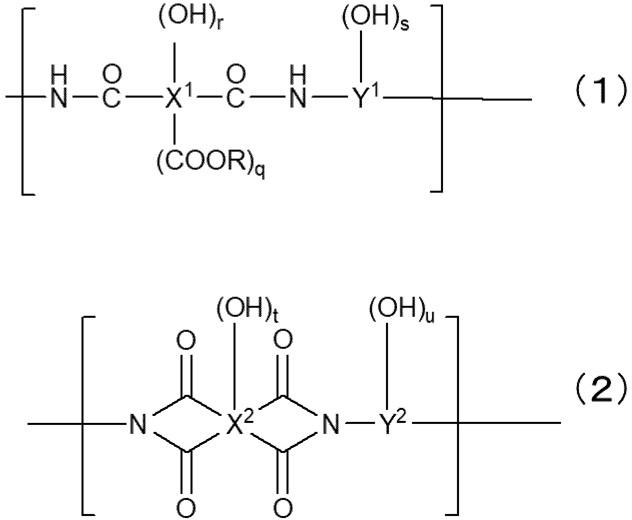

In the general formulas (1) and (2), X¹ and X² each independently represent a di- to octa-valent organic group, Y¹ and Y² each independently represent a di- to hexa-valent organic group, R represents a hydrogen atom or an organic group having 1 to 20 carbon atoms, q is an integer of 0 to 2, and r, s, t and u are each independently an integer of 0 to 4.

X¹ and X² in the general formulas (1) and (2) each independently indicate a di- to deca-valent organic group, and represent a carboxylic acid residue. Y¹ and Y² indicates a di- to tetra-valent organic group, and represents a diamine residue.

The component (A) preferably has an alicyclic structure. When the component (A) has an alicyclic structure, the transparency of the resin composition is improved and the pattern processability is improved. The component (A) more preferably has a carboxylic acid residue having an alicyclic structure in view of improving the solubility of the resin composition. Furthermore, the component (A) particularly preferably has an organic group derived from an alicyclic tetracarboxylic dianhydride having a polycyclic structure in view of improving the chemical resistance and improving the ion migration resistance when formed into a cured product.

Specific examples of the alicyclic tetracarboxylic dianhydride having a polycyclic structure include 4-(2,5-dioxotetrahydrofuran-3-yl)-1,2,3,4-tetrahydronaphthalene-1,2-dicarboxylic dianhydride, 4-(2,5-dioxotetrahydrofuran-3-yl)-4-methyl-1,2,3,4-tetrahydronaphthalene-1,2-dicarboxylic dianhydride, 4-(2,5-dioxotetrahydrofuran-3-yl)-7-methyl-1,2,3,4-tetrahydronaphthalene-1,2-dicarboxylic dianhydride, norbornane-2-spiro-2'-cyclopentanone-5'-spiro-2"-norbornane-5,5",6,6"-tetracarboxylic dianhydride, norbornane-2-spiro-2'-cyclohexanone-6'-spiro-2"-norbornane-5,5",6,6"-tetracarboxylic dianhydride and the like.

It is possible to include, as the carboxylic acid residue, an organic group derived from dianhydrides other than the alicyclic tetracarboxylic dianhydride having the polycyclic structure. Specific examples thereof include, but are not limited to, aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorenic dianhydride, 9,9-bis{4-(3,4-dicarboxyphenoxy)phenyl}fluorenic dianhydride, 2,3,6,7-naphthalenetetracarboxylic dianhydride, 2,3,5,6-pyridine tetracarboxylic dianhydride, 3,4,9,10-perylenetetracarboxylic dianhydride and 2,2-bis(3,4-dicarboxyphenyl)hexafluoropropane dianhydride; 3,3',4,4'-diphenylsulfonetetracarboxylic dianhydride, 1,2,3,4-cyclobutanetetracarboxylic dianhydride, 1,2,3,4-cyclopentanetetracarboxylic dianhydride, 1,2,4,5-cyclohexanetetracarboxylic dianhydride, 5-(2,5-dioxotetrahydrofuryl)-3-methyl-3-cyclohexene-1,2-dicarboxylic dianhydride, 2,3,5-tricarboxy-2-cyclopentaneacetic dianhydride, 2,3,4,5-tetrahydrofurantetracarboxylic dianhydride and the like. These are used alone or in combination of two or more thereof.

The component (A) preferably has a phenolic hydroxyl group, and it is particularly preferable that, in the component (A), Y¹ and Y² in the general formulas (1) and (2) include a diamine residue having a phenolic hydroxyl group. Since moderate solubility of the resin in an alkaline developer can be obtained by including the diamine residue having a phenolic hydroxyl group, high contrast between the exposed area and the unexposed area can be obtained, and a desired pattern can be formed.

Specific examples of the diamine having a phenolic hydroxyl group include, but are not limited to, aromatic diamines such as bis(3-amino-4-hydroxyphenyl)hexafluoropropane, bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, 2,2'-ditrifluoromethyl-5,5'-dihydroxyl-4,4'-diaminobiphenyl, bis(3-amino-4-hydroxyphenyl)fluorene and 2,2'-bis(trifluoromethyl)-5,5'-dihydroxybenzidine, compounds obtained by substituting some of hydrogen atoms of these aromatic rings and hydrocarbons with an alkyl or fluoroalkyl group having 1 to 10 carbon atoms, a halogen atom or the like, and diamines having the structures shown below. These two or more diamine components may be used in combination.

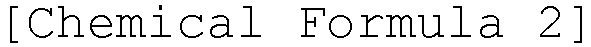

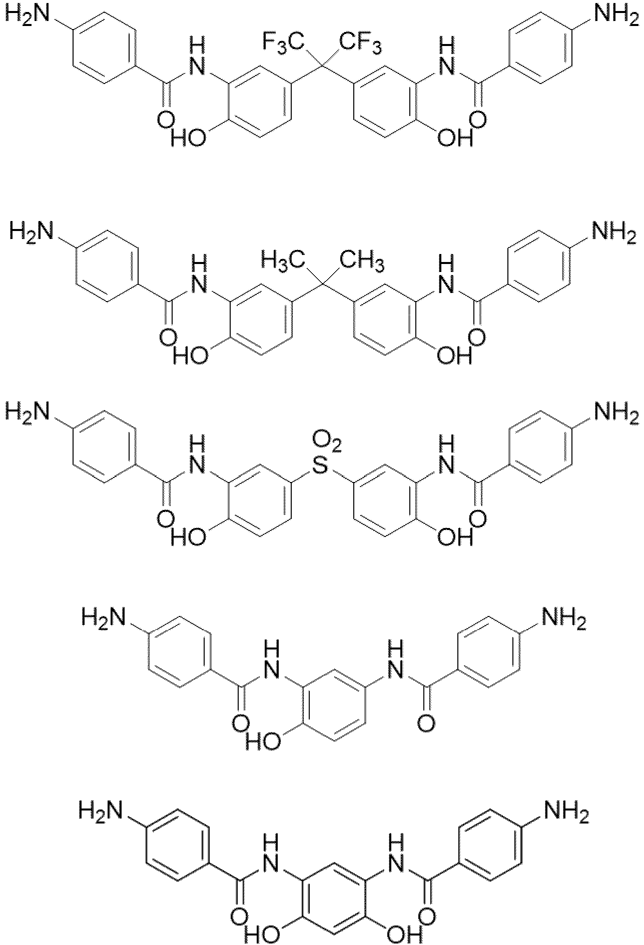

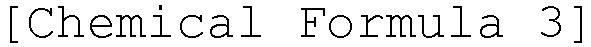

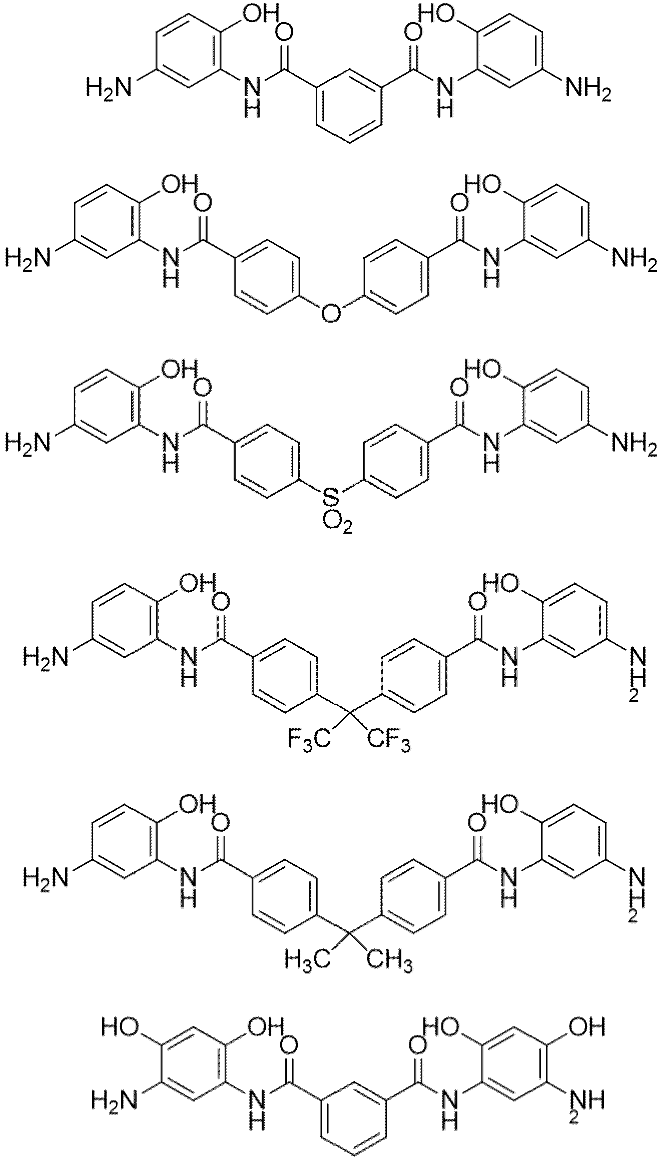

Y¹ and Y² in the general formulas (1) and (2) may include diamine residue having aromatic series other than the above. By copolymerizing these, the heat resistance can be improved. Specific examples of the diamine residue having aromatic series include, but are not limited to, aromatic diamines such as 3,4'-diaminodiphenyl ether, 4,4'-diaminodiphenyl ether, 3,4'-diaminodiphenylmethane, 4,4'-diaminodiphenylmethane, 3,4'-diaminodiphenylsulfone, 4,4'-diaminodiphenylsulfone, 3,4'-diaminodiphenylsulfide, 4,4'-diaminodiphenylsulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl and 2,2'-bis(trifluoromethyl)-4,4'-diaminobiphenyl, and compounds obtained by substituting some of hydrogen atoms of these aromatic rings and hydrocarbons with an alkyl group or a fluoroalkyl group having 1 to 10 carbon atoms, a halogen atom or the like. The other diamine to be copolymerized can be used as it is, or as a corresponding diisocyanate compound or trimethylsilylated diamine. These two or more diamine components may be used in combination.

The molar ratio of the structures represented by the general formulas (1) and (2) in the component (A) can be calculated by the molar ratio of monomers used upon polymerization. When the molar ratio of the structures is determined from the obtained resin, resin composition or cured film, it is possible to confirm in a method for detecting peaks of a polyamide structure, an imide precursor structure or an imide structure using a nuclear magnetic resonance apparatus (NMR).

The component (A) having the structure in which the molecular chain terminal is derived from the carboxylic acid residue can be obtained, for example, in the case of a polyimide having the structure in which the molecular chain terminal is derived from the carboxylic acid residue, by increasing the content of an acid anhydride with respect to the diamine used during polymerization. As another method for obtaining the component (A) having the structure in which the molecular chain terminal is derived from the carboxylic acid residue, it is also possible to obtain by using a specific compound generally used as a terminal-blocking agent, specifically, a compound selected from an acid anhydride, a monocarboxylic acid, a monoacid chloride compound and a monoactive ester compound during polymerization.

By blocking the molecular chain terminal of the component (A) with a terminal-blocking agent of a carboxylic acid or acid anhydride having a hydroxyl group, a carboxyl group, a sulfonic acid group, a thiol group, a vinyl group, an ethynyl group or an allyl group, it is possible to easily adjust the dissolution rate of the component (A) in an aqueous alkali solution and the mechanical properties of the resulting cured film within preferable ranges. A plurality of terminal-blocking agents may be reacted to introduce a plurality of different terminal groups.

Acid anhydrides, monocarboxylic acids, monoacid chloride compounds and monoactive ester compounds suitable as the terminal-blocking agent are preferably acid anhydrides such as phthalic anhydride, maleic anhydride, nadic anhydride, cyclohexanedicarboxylic anhydride and 3-hydroxyphthalic anhydride; monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, 1-mercapto-5-carboxynaphthalene, 3-carboxybenzenesulfonic acid and 4-carboxybenzenesulfonic acid, and monoacid chloride compounds in which these carboxyl groups are acid chlorinated; monoacid chloride compounds in which only one carboxyl group of dicarboxylic acids such as terephthalic acid, phthalic acid, maleic acid, cyclohexane dicarboxylic acid, 1,5-dicarboxynaphthalene, 1,6-dicarboxynaphthalene, 1,7-dicarboxynaphthalene, and 2,6-dicarboxynaphthalene is acid chlorinated; and active ester compounds obtained by the reaction of a monoacid chloride compound with N-hydroxybenzotriazole, imidazole or N-hydroxy-5-norbornene-2,3-dicarboximide, and the like. Two or more of these compounds may be used.

The component (A) into which these terminal-blocking agents are introduced has the structure in which the molecular chain terminal is derived from the carboxylic acid residue. The terminal-blocking agent introduced into the component (A) can be easily detected by the following methods. For example, the component (A) into which the terminal-blocking agent is introduced is dissolved in an acidic solution to be decomposed into an amine component and an acid anhydride component which are constituent units, and the terminal-blocking agent used in the present invention can be easily detected by a gas chromatography (GC) or NMR. Alternatively, the terminal-blocking agent can be easily detected by directly measuring the resin component into which the terminal-blocking agent is introduced by a pyrolysis gas chromatography (PGC), or an infrared spectroscopy and a ¹³C-NMR spectroscopy.

In the present invention, the component (A) is synthesized, for example, by the following methods, but is not limited thereto. For example, when the component (A) is polyimide, a polyimide precursor is obtained by using methods such as a method in which a tetracarboxylic dianhydride, a diamine compound and a monoamine are reacted at low temperature, a method in which a tetracarboxylic dianhydride, a dicarboxylic anhydride and a diamine compound are reacted at low temperature, and a method in which a diester is obtained from a tetracarboxylic dianhydride and an alcohol, and then the resulting diester is reacted with a diamine and a monoamine in the presence of a condensing agent are used to obtain. Thereafter, a polyimide can be synthesized using a well-known imidization reaction method. When the terminal-blocking agent is introduced, a polyimide is synthesized by replacing a part of the diamine with a primary monoamine, or by replacing a part of the tetracarboxylic dianhydride with the dicarboxylic anhydride as the terminal-blocking agent.

It is preferable that the component (A) is polymerized by the above method and, after charging into a large amount of water or a mixed solution of methanol and water, followed by precipitation, filtration, drying and further isolation. The drying temperature is preferably 40 to 100°C, and more preferably 50 to 80°C. By this operation, the unreacted monomers and oligomer components such as dimers and trimers are removed, thus enabling an improvement in film properties after thermal curing.

When the component (A) is the polyimide, the imidization rate can be easily determined, for example, by the following method. First, the infrared absorption spectrum of the polymer is measured to confirm the presence of an absorption peak (around 1,780 cm⁻¹ and around 1,377 cm⁻¹) of the imide structure originated from the polyimide. Next, those obtained by a heat treatment of the polymer at 350°C for 1 hour are used as a sample having an imidization rate of 100%, and an infrared absorption spectrum thereof is measured in the same manner. The content of imide groups in the polymer before the heat treatment is calculated by comparing peak intensities around 1,377 cm⁻¹ of the resin before and after the heat treatment to determine the imidization rate. The imidization rate is preferably 50% or more, and more preferably 80% or more, in view of suppressing a change in the ring-closing rate during thermal curing and obtaining the effect of reducing the stress.

When the total of the entire resin compositions is 100% by mass, the total content of the component (A) is preferably 15 to 60% by mass, and more preferably 25 to 50% by mass. It is preferable that mechanical properties and thermal properties can be improved by including the component (A) in an amount of 15% by mass or more in 100% by mass of the entire resin composition. It is preferable that development residues can be reduced by including the component (A) in an amount of 60% by mass or less. Here, the entire resin composition refers to the total of all components excluding the solvent among the components constituting the resin composition.

### <Component (B)>

The resin composition of the present invention includes, as the component (B), a cationic polymerizable compound. It is important that the component (B) includes both an epoxy compound as a component (B1) and an oxetane compound as a component (B2).

Known epoxy compounds can be used as the component (B1) and it is possible to use, for example, an aromatic epoxy compound, an alicyclic epoxy compound and an aliphatic epoxy compound.

Examples of the aromatic epoxy compound include a glycidyl ether of a monovalent or polyvalent phenol (phenol, bisphenol A, phenol novolac, and a compound that is an alkylene oxide adduct thereof) having at least one aromatic ring.

Examples of the alicyclic epoxy compound include a compound obtained by epoxidizing a compound having at least one cyclohexene or cyclopentene ring with an oxidizing agent (3,4-epoxycyclohexylmethyl-3,4-epoxycyclohexanecarboxylate and the like).

Examples of the aliphatic epoxy compound include a polyglycidyl ether of an aliphatic polyhydric alcohol or an alkylene oxide adduct thereof (1,4-butanediol diglycidyl ether, 1,6-hexanediol diglycidyl ether, and the like), a polyglycidyl ester of an aliphatic polybasic acid (diglycidyl tetrahydrophthalate and the like), and an epoxidized product of a long chain unsaturated compound (epoxidized soybean oil, epoxidized polybutadiene and the like).

It is preferable that the component (B1) further contains an epoxy compound represented by the general formula (3) or (4).

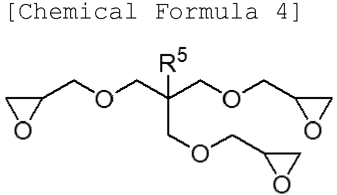

In the general formula (3), R⁵ is a monovalent organic group. The monovalent organic group is preferably a group selected from a hydrogen atom, a hydrocarbon group, and a functional group having an oxygen atom such as a hydroxy group, an alkoxy group or a hydrocarbon group having an ether bond. Examples of the hydrocarbon group include an alkyl group having 1 or more and 8 or less carbon atoms, an alkenyl group having 2 or more and 8 or less carbon atoms, an aryl group having 6 or more and 30 or less carbon atoms and the like. Examples of the alkoxy group include an alkyloxy group having 1 or more and 8 or less carbon atoms, a glycidyl group and the like. Examples of the hydrocarbon group having an ether bond include a group in which an ether bond is inserted into a carbon chain of the hydrocarbon group.

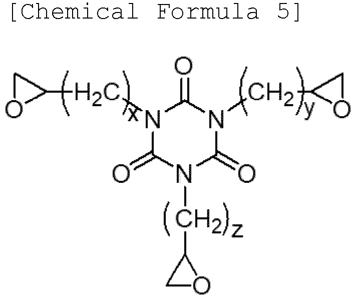

In the general formula (4), x, y and z each independently represent an integer of 1 to 6.

It is preferable that when the component (B1) contains an epoxy compound represented by the general formula (3) or (4), the compatibility with the component (A) is improved and fine pattern processability is obtained, and also the heat resistance and chemical resistance of the cured film are improved.

Examples of the epoxy compound represented by the general formula (3) include SHOWFREE PETG (trade name, manufactured by Showa Denko K.K.) and the like. Examples of the epoxy compound represented by the general formula (4) include TEPIC-VL (trade name, manufactured by Nissan Chemical Industries, Ltd.) and the like.

Known oxetane compounds can be used as the component (B2). It is possible to use, for example, 3-ethyl-3-hydroxymethyloxetane, 2-ethylhexyl(3-ethyl-3-oxetanylmethyl)ether, 2-hydroxyethyl(3-ethyl-3-oxetanylmethyl)ether, 2-hydroxypropyl(3-ethyl-3-oxetanylmethyl)ether, 1,4-bis[(3-ethyl-3-oxetanylmethoxy)methyl]benzene, oxetanyl silsesquioxetane and phenol novolac oxetane.

The component (B2) is preferably an oxetane compound having two or more oxetanyl groups in one molecule, and the number of oxetanyl groups in one molecule is more preferably 2 or more and 6 or less. It is preferable that the curability is improved when the oxetane compound has two or more oxetanyl groups in view of improving the curability. It is preferable that cracks generated during pattern processing can be suppressed when the oxetane compound has 6 or less oxetanyl groups. Examples of such oxetane compound include OXT-121 and OXT-221 (both are trade names, manufactured by Toagosei Co., Ltd.), ETERNACOLL OXBP, ETERNACOLL OXIPA (both are trade names, manufactured by UBE Corporation) and the like.

The component (B2) preferably contains an oxetane compound represented by the general formula (5) or (6).

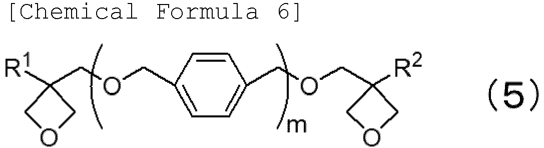

In the general formula (5), m is an integer of 1 to 6, and R¹ and R² are monovalent organic groups. Preferable examples of the monovalent organic group include those which are the same as mentioned in R⁵.

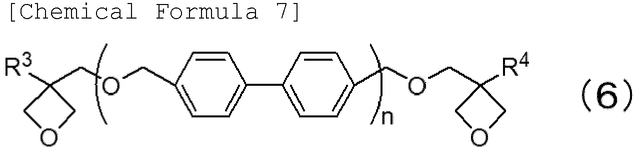

In the general formula (6), n is an integer of 1 to 6, and R³ and R⁴ are monovalent organic groups. Preferable examples of the monovalent organic group include those which are the same as mentioned in R⁵.

It is preferable that the adhesion to the substrate is improved, thus making it possible to suppress peeling during development when the component (B2) contains an oxetane compound represented by the general formula (5). Examples of such oxetane compound include OXT-121 (trade name, manufactured by Toagosei Co., Ltd.) and the like.

It is preferable that the adhesion to the substrate is improved, thus making it possible to suppress peeling during development and to improve the heat resistance of the cured film when the component (B2) contains an oxetane compound represented by the general formula (6). Examples of such oxetane compound include ETERNACOLL OXBP (trade name, manufactured by UBE Corporation) and the like.

Regarding the content of the component (B2), the total of the component (B2) is preferably 10 to 200 parts by mass, and more preferably 20 to 100 parts by mass, when the total of the component (B1) is 100 parts by mass. It is preferable that the cationic polymerizability is improved, thus making it possible to suppress distortion and peeling during pattern processing when the total of the component (B2) is 10 parts by mass or more, and it is preferable that the resolution during pattern processing is improved when the total is 200 parts by mass or less.

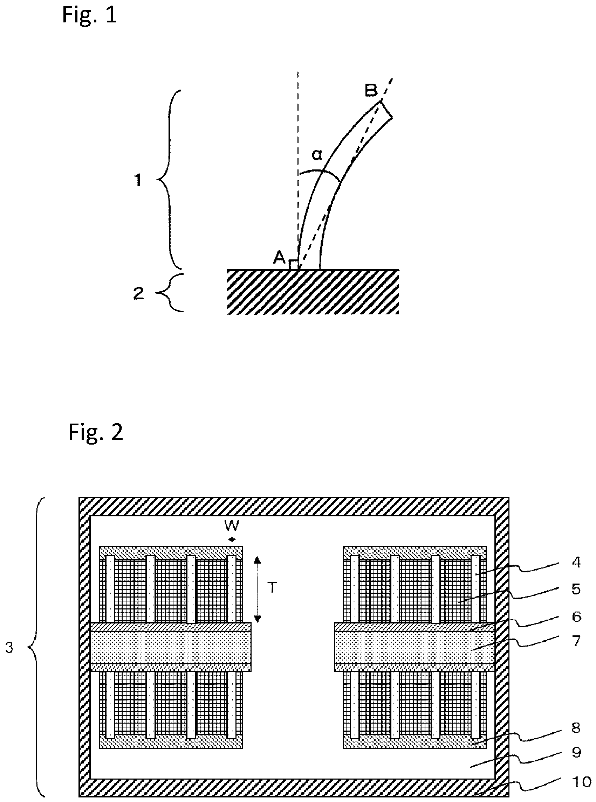

Here, distortion occurring during pattern processing will be described with reference to FIG. 1. FIG. 1 is a cross-sectional view schematically showing distortion of a pattern 1 obtained by laminating a resin composition on a base material 2 and developing the resin composition. The term "distortion" occurring during pattern processing means a phenomenon in which the pattern 1 of the resin composition is formed at an angle away from vertical, as shown in FIG. 1, whereas a perpendicular pattern should be formed in reality. In particular, a state where the angle α between a perpendicular line drawn from an intersection point A of the base material 2 and the pattern 1 in FIG. 1 to the base material 2 and a straight line connecting the intersection point A and an upper corner B of the pattern 1 is 10 to 90° is defined as a state where the distortion of the pattern occurs. In other words, in the resin composition of the present invention, when the content of the component (B2) satisfies the above, the angle α in FIG. 1 can be made less than 10°.

The resin composition of the present invention may further include a cationic polymerizable compound other than the components (B1) and (B2). Examples of the cationic polymerizable compound other than the components (B1) and (B2) include an ethylenically unsaturated compound (vinyl ether and styrenes), a bicyclo orthoester, a spiro orthocarbonate and a spiroortho ester.

Known cationic polymerizable monomers and the like can be used as the ethylenically unsaturated compound, and include an aliphatic monovinyl ether, an aromatic monovinyl ether, a polyfunctional vinyl ether, styrene and a cationic polymerizable nitrogen-containing monomer.

Examples of the aliphatic monovinyl ether include methyl vinyl ether, ethyl vinyl ether, butyl vinyl ether and cyclohexylvinyl ether.

Examples of the aromatic monovinyl ether include 2-phenoxyethyl vinyl ether, phenyl vinyl ether and p-methoxyphenyl vinyl ether.

Examples of the polyfunctional vinyl ether include butanediol-1,4-divinyl ether and triethylene glycol divinyl ether.

Examples of the styrenes include styrene, α-methylstyrene, p-methoxystyrene and p-tert-butoxystyrene.

Examples of the cationic polymerizable nitrogen-containing monomer include N-vinylcarbazole and N-vinylpyrrolidone.

Examples of the bicyclo orthoester include 1-phenyl-4-ethyl-2,6,7-trioxabicyclo[2.2.2]octane and 1-ethyl-4-hydroxymethyl-2,6,7-trioxabicyclo-[2.2.2]octane.

Examples of the spiro orthocarbonate include 1,5,7,11-tetraoxaspiro[5.5]undecane and 3,9-dibenzyl-1,5,7,11-tetraoxaspiro[5.5]undecane.

Examples of the spiroortho ester include 1,4,6-trioxaspiro[4.4]nonane, 2-methyl-1,4,6-trioxaspiro[4.4]nonane and 1,4,6-trioxaspiro[4.5]decane.

When the total of the component (B) is 100 parts by mass, the total of the component (B) other than the components (B1) and (B2) is preferably 10 parts by mass or less, and more preferably 5 parts by mass or less. It is preferable that the cationic polymerizability is improved, thus making it possible to suppress the distortion and peeling during pattern processing when the total of the component (B) other than the components (B1) and (B2) is 10 parts by mass or less.

Regarding the content of the component (B), the total of the component (B) is preferably 50 to 200 parts by mass, and more preferably 70 to 150 parts by mass, when the total of the component (A) is 100 parts by mass. It is preferable that the cationic polymerizability is improved, thus making it possible to suppress the distortion and peeling during pattern processing when the total of the component (B) is 50 parts by mass or more, and it is preferable that the resolution during pattern processing is improved when the total is 200 parts by mass or less.

### <Component (C)>

The resin composition of the present invention includes, as a component (C), a photocationic polymerization initiator. The component (C) generates an acid by light, thus causing cationic polymerization of the cationic polymerizable compound. As the component (C), known compounds can be used as the photocationic polymerization initiator, and an onium salt is preferable.

Specific examples of the component (C) include aromatic iodonium complex salts, aromatic sulfonium complex salts, aromatic borate complex salts, aromatic gallate complex salts and the like. Specific examples of the aromatic iodonium complex salts include diphenyliodonium tetrakis(pentafluorophenyl)borate, diphenyliodonium hexafluoro phosphate, diphenyliodonium hexafluoro antimonate, di(4-nonylphenyl)iodonium hexafluoro phosphate and the like. These photocationic polymerization initiators may be used alone or in combination of two or more thereof.

The content of the component (C) is preferably 0.3 part by mass or more, more preferably 0.5 part by mass or more, and still more preferably 0.7 part by mass or more, when the total of the component (A) is 100 parts by mass. Therefore, the cationic polymerizable compound can exhibit sufficient curability, thus making it possible to improve the pattern processability. Meanwhile, the content of the component (C) is preferably 10 parts by weight or less, and more preferably 8 parts by weight or less, when the total of the component (A) is 100 parts by mass in view of improving the storage stability of the resin composition before curing.

### <Other Components>

The resin composition of the present invention may include a sensitizer. The sensitizer is a compound which can absorb light, provide the absorbed light energy to the component (C) and generate an acid, thus causing cationic polymerization. The sensitizer absorbs light of the emission wavelength during pattern processing, thus enabling reduction in transmittance of the resin composition coating film formed from the resin composition. Therefore, it becomes possible to arbitrarily control the transmittance of the resin composition coating film by adjusting the content of the sensitizer in the resin composition.

The sensitizer is not particularly limited, but is preferably an anthracene compound, and more preferably an anthracene compound having alkoxy groups at the 9- and 10-positions (9,10-dialkoxy-anthracene derivative). Examples of the alkoxy group include C1-C4 alkoxy groups such as a methoxy group, an ethoxy group and a propoxy group. The 9,10-dialkoxy-anthracene derivative may further have a substituent. Examples of the substituent include halogen atoms such as a fluorine atom, a chlorine atom, a bromine atom and an iodine atom; C1-C4 alkyl groups such as a methyl group, an ethyl group and a propyl group; a sulfonic acid alkyl ester group, a carboxylic acid alkyl ester group and the like. Examples of the alkyl in the sulfonic acid alkyl ester group and the carboxylic acid alkyl ester include C1-C4 alkyls such as methyl, ethyl and propyl. The substitution position of these substituents is preferably the 2-position.

The content of the sensitizer is not particularly limited, but is preferably 0.05% by mass or more, and more preferably 0.1% by mass or more, when the mass of the entire resin compositions is 100% by mass. This makes it possible to reduce the transmittance of the resin composition coating, and even on a substrate having rough surface such as ceramics, reflected light from the substrate surface is suppressed, thus facilitating the processing of fine patterns. Meanwhile, in view of suppressing deterioration of the mechanical properties and thermal properties of the cured film of the resin composition coating film formed from the resin composition, the content of the sensitizer is preferably 10% by mass or less, and more preferably 5% by mass or less, when the mass of the entire resin composition is 100% by mass.

The resin composition of the present invention may include a thermal crosslinking agent. The thermal crosslinking agent is preferably a compound having an alkoxymethyl group or a methylol group.

Examples of the compound having an alkoxymethyl group or a methylol group include DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA and HMOM-TPHAP (the above are trade names, manufactured by Honshu Chemical Industry Co., Ltd.), and NIKALAC (registered trademark) MX-290, NIKALAC (registered trademark) MX-280, NIKALAC (registered trademark) MW-100LM and NIKALAC (registered trademark) MX-750LM (the above are trade names, manufactured by SANWA CHEMICAL CO., LTD.).

The resin composition of the present invention can further include a silane compound. The adhesion of the resulting heat resistance resin coating film is improved by including the silane compound. Specific examples of the silane compound include N-phenylaminoethyltrimethoxysilane, N-phenylaminoethyltriethoxysilane, N-phenylaminopropyltrimethoxysilane, N-phenylaminopropyltriethoxysilane, N-phenylaminobutyltrimethoxysilane, N-phenylaminobutyltriethoxysilane, vinyltrimethoxysilane, vinyltriethoxysilane, vinyltrichlorosilane, vinyltris(β-methoxyethoxy)silane, 3-methacryloxypropyltrimethoxysilane, 3-acryloxypropyltrimethoxysilane, p-styryltrimethoxysilane, 3-methacryloxypropylmethyldimethoxysilane, 3-methacryloxypropylmethyldiethoxysilane and the like.

As necessary, the resin composition of the present invention may include surfactants; esters such as ethyl lactate and propylene glycol monomethyl ether acetate; alcohols such as ethanol; ketones such as cyclohexanone and methyl isobutyl ketone; and ethers such as tetrahydrofuran and dioxane for the purpose of improving the wettability with a support. Inorganic particles such as silicon dioxide and titanium dioxide, or powders of polyimide may be included for the purpose of suppressing the thermal expansion coefficient, increasing the dielectric constant and decreasing the dielectric constant.

### <Resin Composition Coating Film, Resin Composition Film>

The shape of the resin composition of the present invention before curing is not limited, and examples thereof include a varnish state and a film shape.

When the resin composition of the present invention is used in a varnish state, it is possible to use a solution obtained by dissolving the components (A) to (C) and components added as necessary in an organic solvent.

When the resin composition of the present invention has a film shape, it may be sometimes referred to as a resin composition coating film in the present invention. The resin composition film of the present invention has a resin composition coating film of the present invention and a support. Namely, the resin composition film of the present invention is a film in which the resin composition coating film of the present invention is formed on the support.

The resin composition coating of the present invention preferably has a film thickness of 40 um or more since a thick layer can be easily formed when producing a semiconductor device having the below-mentioned cured film of the present invention. The film thickness is preferably 70 um or less since variation in film thickness can be suppressed.

Next, a method for fabricating a resin composition film using the resin composition in a varnish state of the present invention will be described. The resin composition film of the present invention is obtained by applying a solution of the resin composition (hereinafter referred to as resin composition varnish) onto a support, followed by drying as necessary. The resin composition varnish is obtained by adding an organic solvent to the resin composition. The organic solvent used here may be any organic solvent that dissolves the resin composition.

Specific examples of the organic solvent include ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether and ethylene glycol dibutyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate and butyl lactate; ketones such as acetone, methyl ethyl ketone, acetylacetone, methyl propyl ketone, methyl butyl ketone, methyl isobutyl ketone, cyclopentanone and 2-heptanone; alcohols such as butyl alcohol, isobutyl alcohol, pentanol, 4-methyl-2-pentanol, 3-methyl-2-butanol, 3-methyl-3-methoxybutanol and diacetone alcohol; aromatic hydrocarbons such as toluene and xylene; and N-methyl-2-pyrrolidone, N-cyclohexyl-2-pyrrolidone, N,N-dimethylformamide, N,N-dimethylacetamide, dimethyl sulfoxide, γ-butyrolactone and the like.

The resin composition varnish may be filtered using a filter paper or a filter. The filtration method is not particularly limited, but is preferably a method for performing filtration by pressure filtration using a filter having a retaining particle diameter of 0.4 um to 10 µm.

The support to be used as the resin composition film is not particularly limited, but various commercially available films such as a polyethylene terephthalate (PET) film, a polyphenylene sulfide film and a polyimide film can be used. The joint surface between the support and the resin composition film may be subjected to a surface treatment with silicone, a silane coupling agent, an aluminum chelating agent, polyurea or the like to improve the adhesion and peelability. The film thickness of the support is not particularly limited, but is preferably within a range of 10 to 100 um from the viewpoint of the workability.

The resin composition film of the present invention may have a protective film on the resin composition film to protect the surface. Thus, the surface of the photosensitive resin composition film can be protected from contaminants such as rubbish and dust in air. Examples of the protective film include a polyolefin film, a polyester film and the like. The protective film preferably has a small adhesive force to the resin composition film.

Examples of the method for applying the resin composition varnish to the support include methods such as spin coating using a spinner, spray coating, roll coating, screen printing, blade coater, die coater, calender coater, meniscus coater, bar coater, roll coater, comma roll coater, gravure coater, screen coater and slit die coater. The film thickness of the coating film varies depending on the application technique, the solid content concentration and the viscosity of the composition and the like, and the film thickness after drying is preferably 0.5 pm or more and 100 µm or less.

For drying, an oven, a hot plate, infrared rays or the like can be used. The drying temperature and the drying time may be within a range where the organic solvent can be volatilized, and it is preferable to appropriately set a range where the photosensitive resin composition film is in an uncured or semi-cured state. Specifically, the drying is preferably performed within a range of 40°C to 120°C for 1 minute to several tens of minutes. The temperature may be raised stepwise by combining these temperatures, and for example, the heat treatment may be performed at 70°C, 80°C and 90°C for 1 minute each.

### <Cured Film, Semiconductor Device, Inductor>

Next, a method for pattern processing of the resin composition varnish of the present invention or the resin composition film using the resin composition varnish will be described by way of Examples.

First, a method for forming a resin composition coating film on a substrate using the resin composition varnish of the present invention, or a resin composition film will be described.

When the resin composition varnish is used, first, the varnish is applied onto the substrate. Examples of the applying method include methods such as spin coating using a spinner, spray coating, roll coating and screen printing. The film thickness of the coating film varies depending on the application technique, the solid content concentration and the viscosity of the resin composition, but it is preferable to apply so that the film thickness after drying is 0.5 um or more and 100 µm or less. Next, the substrate applied with the resin composition varnish is dried to obtain a resin composition coating film. For drying, an oven, a hot plate, infrared rays or the like can be used. The drying temperature and the drying time may be within a range where the organic solvent can be volatilized, and it is preferable to appropriately set a range where the resin composition coating film is in an uncured or semi-cured state. Specifically, the drying is preferably performed within a range of 50 to 150°C for 1 minute to several hours.

Meanwhile, when using the resin composition film, in the case of having a protective film, the protective film is peeled off, and the resin composition coating film in the resin composition film and the substrate are opposed to each other and bonded by thermocompression bonding to obtain a substrate with the resin composition coating film formed thereon. The thermocompression bonding can be performed by a heat press treatment, a heat lamination treatment, a heat vacuum lamination treatment or the like. The bonding temperature is preferably 40°C or higher in view of the adhesion and embeddability to the substrate. To keep prevent the resin composition film from being cured upon bonding and the resolution of pattern formation in exposure and development steps from deteriorating, the bonding temperature is preferably 150°C or lower. After thermocompression bonding, the support may be peeled off from the resin composition film as necessary.

In any case, examples of the substrate to be used include, but are not limited thereto, a silicon wafer, ceramics, gallium arsenide, an organic circuit board, an inorganic circuit board, and those in which a constituent material of a circuit is disposed on these substrates. Examples of the organic circuit board include glass base material copper clad laminates such as a glass fabric/epoxy copper clad laminate plate; composite copper clad laminate plates such as a glass nonwoven fabric/epoxy copper clad laminate; heat resistant and thermoplastic substrates such as a polyetherimide resin substrate, a polyether ketone resin substrate and a polysulfone-based resin substrate; and flexible substrates such as a polyester copper clad film substrate and a polyimide copper clad film substrate. Examples of the inorganic circuit board include ceramic substrates such as an alumina substrate, an aluminum nitride substrate and a silicon carbide substrate; and metal-based substrates such as an aluminum base substrate and an iron base substrate. Examples of the constituent material of the circuit include a conductor containing metals such as silver, gold and copper; resistors containing an inorganic-based oxide or the like; low dielectrics containing a glass-based material and/or a resin; high dielectrics containing a resin, an inorganic particle having high dielectric constant or the like; and insulators containing a glass-based material or the like.

Next, the resin composition coating film formed by the above method is irradiated with actinic radiation through a mask having a desired pattern to be exposed. Examples of the actinic radiation used for exposure include ultraviolet rays, visible rays, electron beams, X-rays and the like. In the present invention, i-line (365 nm), h-line (405 nm) or g-line (436 nm) of a mercury lamp is preferably used. In the resin composition film, when the support has the quality of material which is transparent to these light rays, exposure may be performed without peeling the support from the resin composition film.

To form a pattern, the exposed area of the resin composition coating film is removed with a developer after exposure. The developer is preferably an aqueous solution of tetramethylammonium hydroxide, or an aqueous solution of a compound exhibiting alkalinity, such as diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine or hexamethylenediamine. In some cases, these aqueous alkaline solutions may contain polar solvents such as N-methyl-2-pyrrolidone, N,N-dimethylformamide, N,N-dimethylacetamide, dimethyl sulfoxide, γ-butyrolactone and dimethylacrylamide; alcohols such as methanol, ethanol and isopropanol; esters such as ethyl lactate and propylene glycol monomethyl ether acetate; and ketones such as cyclopentanone, cyclohexanone, isobutyl ketone and methyl isobutyl ketone, alone or in combination of several types.

Development can be performed by a method for spraying the above developer on the coating film surface, liquidplating the developer on the surface of the resin composition coating film, immersing the resin composition coating film in the developer, or immersing the resin composition coating film and applying ultrasonic waves therein. Development conditions such as the development time and the temperature of the developer in the developing step may be conditions under which the exposed area is removed and the pattern can be formed.

After development, a rinsing treatment is preferably performed with water. Here, alcohols such as ethanol and isopropyl alcohol; and esters such as ethyl lactate and propylene glycol monomethyl ether acetate may also be added to water to perform a rinsing treatment.

A baking treatment of the resin composition coating film may be performed before development as necessary. As a result, the resolution of the pattern after development may be improved and the allowable range of development conditions may increase. The temperature of the baking treatment is preferably within a range of 50 to 180°C, and in particular, more preferably within a range of 60 to 120°C. The time is preferably 5 seconds to several hours.

After formation of the pattern, the unreacted photocationic polymerizable compound and the cationic polymerization initiator remain in the resin composition coating film. For this reason, upon thermocompression bonding or curing, these may be thermally decomposed to generate gas. To avoid this, it is preferable to irradiate the entire surface of the resin composition coating film after formation of the pattern with the above exposure light to generate an acid from the unreacted cationic polymerization initiator. As a result, a reaction of the unreacted cationic polymerizable compound proceeds upon thermocompression bonding or curing, and generation of gas derived from thermal decomposition can be suppressed.

After development, a thermal crosslinking reaction is allowed to proceed by applying the temperature of 150°C to 500°C to obtain a cured film. This step is called curing. The heat resistance and the chemical resistance of the resulting cured film can be improved by crosslinking. It is possible to select, as the method for the heat treatment, a method for selecting the temperature and raising the temperature stepwise or a method for selecting a certain temperature range and performing the heat treatment for 5 minutes to 5 hours while continuously raising the temperature. An example of the former includes a method in which the heat treatment is performed at 130° C and 200°C for 30 minutes each. An example of the latter includes a method for linearly raising the temperature from room temperature to 400°C over 2 hours.

The cured film of the present invention is a cured film obtained by curing the resin composition coating film in the resin composition of the present invention or the resin composition film of the present invention. The cured film obtained by curing the resin composition coating film in the resin composition or the resin composition film of the present invention can be used for electronic components such as semiconductor devices.

The cured film of the present invention preferably has a thickness of 40 um or more, and more preferably 80 um or more, from the viewpoints that a thicker insulating layer can be formed and wiring density can be improved when fabricating a semiconductor device having the above-mentioned cured film of the present invention. The thickness is preferably 300 µm or less, and more preferably 200 um or less since warpage of the semiconductor device due to film stress can be reduced.

The semiconductor device of the present invention is a semiconductor device having a cured film of the present invention. Here, the semiconductor device refers to a general device that can function by utilizing characteristics of a semiconductor element. An electrooptical device or a semiconductor circuit board in which a semiconductor element is connected to a substrate, a device in which a plurality of semiconductor elements are laminated, and an electronic device including these are all included in the semiconductor device. Electronic components such as a multilayer wiring board for connecting the semiconductor elements are also included in the semiconductor device. Specifically, the cured film of the present invention is suitably used for applications such as an insulating film of an inductor, a passivation film of a semiconductor, a surface protective film of a semiconductor element, an interlayer insulating film between a semiconductor element and wiring, an interlayer insulating film between a plurality of semiconductor elements, an interlayer insulating film between wiring layers of a multilayer wiring for high-density mounting, and an insulating layer of an organic electroluminescent element, but is not limited thereto, and can be used for various applications.

The resin composition of the present invention is characterized in that it can be patterned with high aspect ratio, and is therefore preferably used for a semiconductor device having a cured film with high aspect ratio, for example, an inductor. FIG. 2 schematically shows a cross-sectional view of an inductor. However, the inductor according to the present invention is not limited to the embodiments described below.

To maintain insulating properties between the inductor 3 and the coil 5 in FIG. 2, an insulating film 4 is provided. It is preferable to use, as the insulating film 4, a cured film obtained by curing the resin composition of the present invention. By using the cured film obtained by curing the resin composition of the present invention as the insulating film 4, sufficient insulation properties can be exhibited even if the insulating film 4 has a small width W, so that the crosssectional area of the wiring of the coil 5 can be increased and the inductance can be increased.

The thickness T of the insulating film 4 using a cured film formed by curing the resin composition of the present invention is preferably 40 um or more, and more preferably 80 um or more, from the viewpoint that the cross-sectional area of the coil 5 can be increased. Since the film stress can be reduced, the thickness T is preferably 300 µm or less, and more preferably 200 µm or less.

Furthermore, the aspect ratio of the insulating film 4 formed using a cured film obtained by curing the resin composition of the present invention is preferably 4 or more, and more preferably 8 or more, from the viewpoint that the wiring density of the coil 5 can be improved. To maintain the insulating properties, the aspect ratio of the insulating film 4 is preferably 30 or less, and more preferably 20 or less. The aspect ratio as used herein is calculated by the following formula (1). Formula (1) (Aspect ratio) = T (film thickness)/W (pattern width).

In the inductor 3, the insulating film 4 made of a cured film obtained by curing the resin composition of the present invention and the coil 5 are formed above and below the substrate 7. It is preferable that a resin layer 6 is further provided between the insulating film 4 and the substrate 7. It is preferable that the adhesion of the insulating film 4 to the substrate is improved by the resin layer 6.

The resin layer 6 preferably contains at least one polymer compound selected from the group consisting of polyamide, polyimide, polyamideimide and polybenzoxazole. The content of the polymer compound in the resin layer 6 is preferably 1 to 45% by mass, and more preferably 20 to 40% by mass. The content is preferably 1% by mass or more is in terms of improving the heat resistance, and preferably 45% by mass or less in terms of improving the adhesion of the insulating film 4 to the base material.

Further, the inductor 3 in FIG. 2 includes an insulating film 8, a magnetic material 9 and a mold resin 10.

### EXAMPLES

The present invention will be illustrated below by way of Examples, but the present invention is not limited thereto.

### <Evaluation of Pattern Processability>

A 5 cm square silicon wafer was used as the substrate. The protective film of the resin composition film fabricated in each of Examples and Comparative Examples was peeled off, and the resin composition film was laminated on the substrate so that the resin composition coating film was in contact with the substrate. A thermal lamination treatment was performed using a vacuum diaphragm type laminator (MVLP-500/600, manufactured by Meiki Co., Ltd.) under the conditions of an upper and lower hot platen temperature of 80°C, a vacuuming time of 20 seconds, a vacuum press time of 30 seconds and a bonding pressure of 0.5 MPa, and then the support was peeled off from the resin composition film to form a resin composition coating film having a film thickness of 45 um on the silicon substrate.

The resin composition coating film thus obtained was subjected to the same process as above once again to laminate a resin composition coating film having a total film thickness of 90 um on the silicon substrate.

Subsequently, a mask having patterns with line widths/space widths of 5 um/50 µm, 6 µm/50 µm, 7 µm/50 um, 8 µm/50 um, 9 µm/50 um, 10 µm/50 µm and 15 um/50 um was set in an exposure apparatus, and exposure was performed at an exposure dose of 1,500 mJ/cm² (in terms of i-line) using an ultra-high pressure mercury lamp equipped with an i-line bandpass filter under the condition of an exposure gap of 100 µm between the mask and the photosensitive resin composition film. After exposure, post exposure baking was performed at 90°C for 10 minutes on a hot plate. Thereafter, the unexposed area was removed by dipping development using a 2.38% by mass aqueous solution of tetramethylammonium hydroxide (TMAH), and then a rinse treatment with water was performed. The development time was twice as long as the time when the unexposed area was completely dissolved.

The pattern thus obtained was observed with an optical microscope, and the minimum line width when there was no abnormalities such as residues on the pattern was taken as the resolution. The aspect ratio was calculated from the minimum line width by the above formula (1). If none of the patterns was resolved, the resolution was recorded as 0 (poor).

### <Evaluation of Glass Transition Temperature>

In the same manner as in the method for evaluating pattern processability, except that the substrate was changed from the silicon wafer to a copper foil (CF-T9DA-SV-1, manufactured by Fukuda Metal Foil & Powder Co., Ltd.) having a plane size of 10 cm × 10 cm, a resin composition coating film was formed on the copper foil. Then, exposure was performed at an exposure dose of 1,000 mJ/cm² (in terms of i-line, full wavelength exposure) using an ultra-high pressure mercury lamp. After exposure, post exposure baking was performed at 120°C for 10 minutes on a hot plate. Then, using an inert oven (INL-60, manufactured by Koyo Thermo Systems Co., Ltd.), the temperature was raised from room temperature to 200°C over 60 minutes under a N₂ atmosphere (oxygen concentration: 20 ppm or less), and then a heat treatment was performed at 200°C for 60 minutes to obtain a cured film of the resin composition film formed on the copper foil. Thereafter, only the copper foil was dissolved in a ferric chloride solution, followed by washing with water and further air drying to obtain a cured film of the resin composition.

The cured film thus obtained was cut into a test piece having a size of 5 mm × 40 mm, and measurement was performed using a dynamic viscoelasticity measuring device DVA-200 (manufactured by IT Measurement Control Co., Ltd.) under the conditions of a distance between chucks of 20 mm, a frequency of 1 Hz, a temperature within a range of room temperature to 350°C, a temperature rising rate of 5°C/min and a measurement strain of 0.1%, and the temperature of peak top of tan δ = storage elastic modulus/loss elastic modulus, from which the ratio of the storage elastic modulus to the loss elastic modulus was taken, was taken as a glass transition temperature.

### <Evaluation of Tensile Strength/Tensile Elongation>

The cured film of the resin composition was obtained in the same manner as in the method for evaluating the glass transition temperature. The cured film thus obtained was cut into a test piece having a size of 10 mm × 80 mm, and the tensile test was performed at room temperature, a distance between chucks of 50 mm and a tensile speed of 50 mm/min using a universal testing machine AG-Xplus (manufactured by Shimadzu Corporation) to measure the tensile strength (stress at break) and the tensile elongation (elongation at break). The measurement was performed on 10 test pieces per specimen, and the average value of the top 5 points was obtained from the results.

The compounds used in each of Examples and Comparative Examples were synthesized by the following methods.

### Synthesis Example 1: Synthesis of Phenolic Hydroxyl Group-Containing Diamine Compound (a)

2,2-Bis(3-amino-4-hydroxyphenyl)hexafluoropropane (hereinafter referred to as BAHF) (18.3 g, 0.05 mol) was dissolved in 100 mL of acetone and propylene oxide (17.4 g, 0.3 mol), followed by cooling to -15°C. A solution obtained by dissolving 3-nitrobenzoyl chloride (20.4 g, 0.11 mol) in 100 mL of acetone was added dropwise thereto. After completion of the dropwise addition, a reaction was performed at -15°C for 4 hours, and then the temperature was returned to room temperature. The precipitated white solid was separated by filtration and then vacuum-dried at 50°C.

The white solid thus obtained (30 g) was placed in a 300 mL stainless steel autoclave and dispersed in 250 mL of methylcellosolve, and 2 g of 5% palladium-carbon was added thereto. Hydrogen was introduced thereinto with a balloon, and a reduction reaction was performed at room temperature. After about 2 hours, the reaction was terminated after confirming that the balloon did not deflate any more. After completing the reaction, the palladium compound as a catalyst was removed by filtration, and the filtrate was concentrated using a rotary evaporator to obtain a hydroxyl group-containing diamine compound (a) represented by the following formula. The obtained solid was used as it was for the reaction.

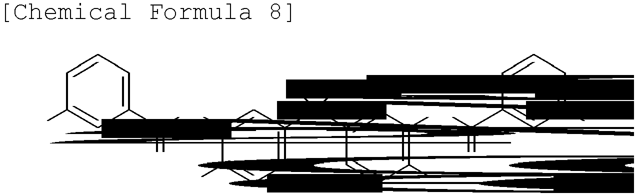

### Synthesis Example 2: Synthesis of Polyamide (A-1)

Under a dry nitrogen stream, BAHF (29.30 g, 0.08 mol) was added to 80 g of y-butyrolactone (hereinafter, referred to as GBL), followed by dissolution with stirring at 120°C. Thereafter, 4-(2,5-dioxotetrahydrofuran-3-yl)-1,2,3,4-tetrahydronaphthalene-1,2-dicarboxylic dianhydride (hereinafter referred to as TDA-100) (30.03 g, 0.1 mol) was added together with 20 g of GBL, followed by stirring at 120°C for 1 hour and further stirring at 200°C for 4 hours to obtain a reaction solution. Next, the reaction solution was charged into 3 L of water to collect a white precipitate. This precipitate was collected by filtration, washed three times with water, and then dried in a vacuum dryer at 80°C for 5 hours.

### Synthesis Example 3: Synthesis of Polyamideimide (A-2)

Under a dry nitrogen stream, a hydroxyl group-containing diamine compound (a) (15.72 g, 0.04 mol) and BAHF (14.65 g, 0.04 mol) were added to 100 g of GBL, followed by stirring at 120°C. Next, TDA-100 (30.03 g, 0.1 mol) was added together with 20 g of GBL, followed by stirring at 120°C for 1 hour and further stirring at 200°C for 4 hours to obtain a reaction solution. Next, the reaction solution was charged into 3 L of water to collect a white precipitate. This precipitate was collected by filtration, washed three times with water, and then dried in a vacuum dryer at 80°C for 5 hours.

### Example 1

Polyimide (A-1) (10 g) as a component (A), 5.6 g of PETG (trade name, manufactured by Showa Denko K.K.) and 3.7 g of BATG (trade name, manufactured by Showa Denko K.K.) as a component (B1), 0.7 g of OXT-101 (trade name, manufactured by Toagosei Co., Ltd.) as a component (B2), 0.3 g of CPI-310FG (trade name, manufactured by San-Apro Ltd.) as a component (C), 0.2 g of UVS-1331 (trade name, manufactured by Kawasaki Kasei Chemicals Ltd.) as a sensitizer, and 0.4 g of KBM-403 (trade name, manufactured by Shin-Etsu Chemical Co., Ltd.) as a silane compound were dissolved in GBL. The addition amount of GBL as the solvent was adjusted so that additives other than the solvent were defined as solid content and the solid content concentration was 60% by weight. The solution thus obtained was subjected to pressure filtration using a filter having a retaining particle diameter of 1 µm to obtain a resin composition varnish having negative photosensitivity.

The resin composition varnish thus obtained was applied onto a PET film having a thickness of 50 um using a comma roll coater, followed by drying at 120°C for 8 minutes to obtain a resin composition film in which the resin composition is formed on the PET film. The film thickness of the resin composition film was adjusted to be 45 um. Thereafter, a PP film having a thickness of 30 um was laminated on the resin composition coating film as a protective film. Using the resin composition film thus obtained, the pattern processability, the glass transition temperature, and the tensile strength and the tensile elongation were evaluated as mentioned above. The results are shown in Table 2.

### Examples 2 to 15

Resin composition films were fabricated in the same manner as in Example 1, except that the components (A) to (C) and other components were changed to the following compounds and the mixing ratios thereof were changed as shown in Table 1, and then the pattern processability, the glass transition temperature, and the tensile strength and tensile elongation were evaluated as mentioned above. The results are shown in Table 2.

### Comparative Examples 1 to 3

Resin composition films were fabricated in the same manner as in Example 1, except that the components (A) to (C) and other components were changed to the following compounds and the mixing ratios thereof were changed as shown in Table 1, and then the pattern processability was evaluated as mentioned above. The results are shown in Table 2.

**[Table 1-1]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Component (A) (parts by mass) | | A-1 | 100 | - | 100 | 100 | 100 | 100 | 100 | 100 | 100 |
| | | A-2 | - | 100 | - | - | - | - | - | - | - |
| Component (B) (parts by mass) | Component (B1) (parts by mass) | B1-1 | 56 | 56 | 18 | 40 | 40 | 40 | 48 | 30 | 20 |
| | | B1-2 | 37 | 37 | 12 | 26 | 26 | 26 | 32 | 20 | 13 |
| | | B1-3 | - | - | - | - | - | - | - | - | - |
| | | B1-4 | - | - | - | - | - | - | - | - | - |
| | Component (B2) (parts by mass) | B2-1 | 7 | 7 | 70 | 33 | - | - | - | - | - |
| | | B2-2 | - | - | - | - | 33 | - | - | - | - |
| | | B2-3 | - | - | - | - | - | 33 | 20 | 50 | 17 |
| | | B2-4 | - | - | - | - | - | - | - | - | - |
| Component (C) (parts by mass) | | C-1 | 3 | 3 | 3 | 3 | 3 | 3 | 3 | 3 | 3 |
| Sensitizer (parts by mass) | | UVS-2171 | 2 | 2 | 2 | 2 | 2 | 2 | 2 | 2 | 2 |
| Silane compound (parts by mass) | | KBM-403 | 4 | 4 | 4 | 4 | 4 | 4 | 4 | 4 | 4 |
| Total content of component (B2) (parts by mass) | | | 7.6 | 7.6 | 233 | 50 | 50 | 50 | 25 | 100 | 50 |
| Total content of component (B) (parts by mass) | | | 100 | 100 | 100 | 99 | 99 | 99 | 100 | 100 | 50 |

**[Table 1-2]**

| | | | Example 10 | Example 11 | Example 12 | Example 13 | Example 14 | Example 15 | Comparative Example 1 | Comparative Example 2 | Comparative Example 3 |
|---|---|---|---|---|---|---|---|---|---|---|---|
| Component (A) (parts by mass) | | A-1 | 100 | 100 | 100 | 100 | 100 | 100 | - | 100 | 100 |
| | | A-2 | - | - | - | - | - | - | - | - | - |
| Component (B) (parts by mass) | Component (B1) (parts by mass) | B1-1 | 48 | 30 | 48 | - | 40 | - | 30 | - | 67 |
| | | B1-2 | 32 | 20 | 32 | - | 26 | - | 20 | - | 33 |
| | | B1-3 | - | - | - | 50 | - | 50 | - | - | - |
| | | B1-4 | - | - | - | - | - | - | 50 | - | - |
| | Component (B2) (parts by mass) | B2-1 | - | - | - | - | - | - | 100 | - | - |
| | | B2-2 | - | - | - | - | - | - | - | - | - |
| | | B2-3 | 80 | 25 | 40 | 50 | - | - | - | 100 | - |
| | | B2-4 | - | - | - | - | 33 | 50 | - | - | - |
| Component (C) (parts by mass) | | C-1 | 3 | 3 | 3 | 3 | 3 | 3 | 3 | 3 | 3 |
| Sensitizer (parts by mass) | | UVS-2171 | 2 | 2 | 2 | 2 | 2 | 2 | 2 | 2 | 2 |
| Silane compound (parts by mass) | | KBM-403 | 4 | 4 | 4 | 4 | 4 | 4 | 4 | 4 | 4 |
| Total content of component (B2) (parts by mass) | | | 50 | 50 | 50 | 100 | 50 | 100 | 100 | - | - |
| Total content of component (B) (parts by mass) | | | 160 | 75 | 120 | 100 | 100 | 100 | - | 100 | 100 |

**[Table 2-1]**

| | | Example 1 | Example 2 | Example 3 | Example 4 | Example 5 | Example 6 | Example 7 | Example 8 | Example 9 |
|---|---|---|---|---|---|---|---|---|---|---|
| Pattern processability | Resolution (µm) | 10 | 10 | 10 | 8 | 7 | 5 | 6 | 6 | 10 |
| Thermal and mechanical properties of material | Aspect ratio | 9 | 9 | 9 | 11.3 | 12.9 | 18 | 15 | 15 | 9 |
| | Glass transition temperature (°C) | 260 | 230 | 225 | 250 | 242 | 240 | 245 | 237 | 248 |
| | Tensile strength (MPa) | 85 | 80 | 80 | 85 | 85 | 90 | 85 | 90 | 75 |
| | Tensile elongation (%) | 6 | 8 | 6 | 6 | 7 | 8 | 7 | 8 | 7 |

**[Table 2-2]**

| | | Example 10 | Example 11 | Example 12 | Example 13 | Example 14 | Example 15 | Comparative Example 1 | Comparative Example 2 | Comparative Example 3 |
|---|---|---|---|---|---|---|---|---|---|---|
| Pattern processability | Resolution (µm) | 8 | 6 | 6 | 7 | 7 | 7 | 10 | 0 | 15 |
| | Aspect ratio | 11.3 | 15 | 15 | 12.9 | 12.9 | 12.9 | 9 | 0 | 6 |
| Thermal and mechanical properties of material | Glass transition temperature (°C) | 238 | 242 | 238 | 220 | 245 | 225 | 160 | 215 | 263 |
| | Tensile strength (MPa) | 75 | 85 | 85 | 80 | 85 | 80 | 60 | 80 | 90 |
| | Tensile elongation (%) | 6 | 7 | 8 | 8 | 7 | 8 | 4 | 6 | 6 |

The "total content (parts by mass) of component (B2)" in Table 1 represents the total parts by mass of the component (B2) when the total of the component (B1) is 100 parts by mass. The "total content (parts by mass) of component (B)" represents the total parts by mass of the component (B) when the total of the component (A) is 100 parts by mass.

As is apparent from Tables 1 and 2, in Comparative Example 1 which does not include the component (A), the glass transition temperature and the tensile strength of the cured film were inferior to those of the Examples. In Comparative Example 2 which does not include the component (B1), clogging occurred in the pattern, thus failing to perform pattern processing. In Comparative Example 3 which does not include the component (B2), distortion and peeling occurred when the pattern became fine, thus failing to perform pattern processing with high aspect ratio.

In contrast, it was shown that the resin composition of the present example had sufficient thermal properties (glass transition temperature) and mechanical properties (tensile strength, tensile elongation), and is capable of forming a pattern with high aspect ratio.

The compounds used in each of Synthesis Examples, Examples and Comparative Examples are shown below.

### (A) Polymer compound

A-1: Polyimide
A-2: Polyamideimide

### (B1) Epoxy compound

B1-1: PETG (manufactured by Showa Denko K.K.), Epoxy compound represented by the general formula (3)
B1-2: BATG (manufactured by Showa Denko K.K.)
B1-3: TEPIC-VL (manufactured by Nissan Chemical Industries, Ltd.), Epoxy compound represented by the general formula (4)
B1-4: 1007 (manufactured by Mitsubishi Chemical Corporation), Bisphenol A type epoxy resin

### (B2) Oxetane compound

B2-1: OXT-101 (manufactured by Toagosei Co., Ltd.), Compound having one oxetanyl group
B2-2: OXT-221 (manufactured by Toagosei Co., Ltd.), Compound having two oxetanyl groups
B2-3: OXT-121 (manufactured by Toagosei Co., Ltd.), Compound which has two oxetanyl groups and is represented by the general formula (5)
B2-4: ETERNACOLL OXBP (manufactured by UBE Corporation), Compound which has two oxetanyl groups and is represented by the general formula (6)

### (C) Cationic polymerization initiator

C-1: CPI-310FG (Onium salt-based photoacid generator, manufactured by San-Apro Ltd.)

### Sensitizer

UVS-2171 (Anthracene compound, manufactured by Kawasaki Kasei Chemicals Ltd.)

### Silane compound

KBM-403 (3-Glycidoxypropyltrimethoxysilane, manufactured by Shin-Etsu Chemical Co., Ltd.)

### DESCRIPTION OF REFERENCE SIGNS

- 1:: Pattern of resin composition
- 2:: Base material
- 3:: Inductor
- 4:: Insulating film
- 5:: Coil
- 6:: Resin layer
- 7:: Substrate
- 8:: Insulating film
- 9:: Magnetic material
- 10:: Mold resin

## Claims

1. A resin composition comprising at least one polymer compound selected from the group consisting of polyamide, polyimide, polyamideimide and polybenzoxazole as a component (A), a cationic polymerizable compound as a component (B), and a photocationic polymerization initiator as a component (C), wherein
the component (B) contains both an epoxy compound as a component (B1) and an oxetane compound as a component (B2) .

2. The resin composition according to claim 1, wherein the total of the component (B2) is 10 to 200 parts by mass when the total of the component (B1) is 100 parts by mass.

3. The resin composition according to claim 1, wherein the component (B2) contains an oxetane compound having two or more oxetanyl groups in one molecule.

4. The resin composition according to claim 1, wherein the component (B2) contains an oxetane compound represented by the general formula (5): 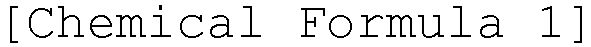 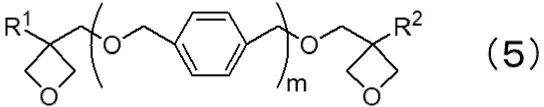 wherein, in the general formula (5), m is an integer of 1 to 6, and R¹ and R² are monovalent organic groups.

5. The resin composition according to claim 1, wherein the component (B2) contains an oxetane compound represented by the general formula (6): 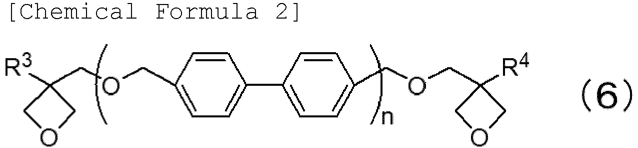 wherein, in the general formula (6), n is an integer of 1 to 6, and R³ and R⁴ are monovalent organic groups.

6. The resin composition according to claim 1, wherein the component (B1) contains an epoxy compound represented by the general formula (3) or (4): 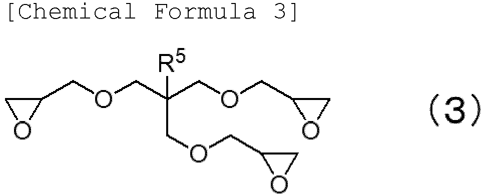 wherein, in the general formula (3), R⁵ is a monovalent organic group, and: 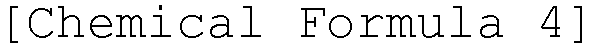 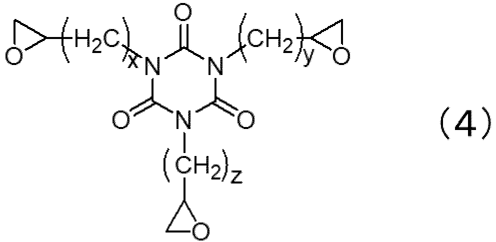 wherein, in the general formula (4), x, y and z each independently represent an integer of 1 to 6.

7. The resin composition according to claim 1, wherein the total of the component (B) is 50 to 200 parts by mass when the total of the component (A) is 100 parts by mass.

8. The resin composition according to claim 1, which is a negative photosensitive resin composition.

9. A resin composition film comprising a resin composition coating film and a support, wherein the resin composition coating film is made of the resin composition according to claim 1.

10. A semiconductor device comprising a cured film formed by curing the resin composition according to claim 1.

11. The semiconductor device according to claim 10, wherein the cured film has a thickness of 40 to 300 µm.

12. The semiconductor device according to claim 10, wherein the cured film has an aspect ratio of 4 to 20.

13. The semiconductor device according to claim 10, wherein the semiconductor device is an inductor comprising an insulating film and a coil, and the cured film formed by curing the resin composition is used as the insulating film of the inductor.

14. The semiconductor device according to claim 13, wherein the semiconductor device is an inductor comprising an insulating film and a coil formed on a substrate, the semiconductor device further comprising a resin layer between the insulating film and the substrate.

15. The semiconductor device according to claim 14, wherein the resin layer contains at least one polymer compound selected from the group consisting of polyamide, polyimide, polyamideimide and polybenzoxazole, and the content of the polymer compound in the resin layer is 1 to 45% by mass.
